# EUROPEAN PATENT APPLICATION

(11) **EP 2 687 350 A1**
(43) Date of publication of application: **22.01.2014**
(21) Application number: 12758262.5
(22) Date of filing: 13.03.2012
(51) Int. Cl.: B29C 45/14, B29C 45/26

(54) **RESIN MOLDED PRODUCT AND METHOD FOR PRODUCING SAME**

(30) Priority: 17.03.2011 JP 2011059672
(71) Applicant: Iriso Electronics Co., Ltd., Kanagawa 222-0033 (JP); Mtec Corporation, Aichi 480-1101 (JP)
(72) Inventor: SUGAYA Yujiro, Yokohama-shi, Kanagawa 222-0033 (JP); KATO Mitsuharu, Aichi-gun, Aichi 480-1101 (JP)
(74) Representative: TBK
(86) International application number: PCT/JP2012/056383
(87) International publication number: WO 2012/124682

(57) **Abstract**

The present invention provides a resin molded product which can reduce the external force that is applied to a first element from each electroconductive member due to a pressure of a resin at the time of molding, when each of the electroconductive members and the first element are insert-molded with the resin, and a method for producing the same. A second element 3 which fixes the electroconductive members 1 to each other is connected to each of the electroconductive members 1 so as to lie astride each of the electroconductive members 1. Accordingly, even though a pressure of the resin which flows into a die has been applied to each of the electroconductive members 1 when a resin part that covers each of the electroconductive members 1 and the first element 2 is formed by insert molding, the distortion occurring among each of the electroconductive members 1 is reduced by the second element 3. Thereby, the method can greatly reduce the external force like twisting and bending, which is applied to the first element 2 from each of the electroconductive members 1, and shows such an advantage as not to degrade characteristics of the first element 2.

## Description

### Technical Field

The present invention relates to a resin molded product which is used for the manufacture of various devices, for instance, such as a pressure sensor and a rotation magnetic sensor for automobiles and insert-molds a workpiece in which a first element is connected to a plurality of electroconductive members with a resin, and a method for producing the same.

### Background Art

When a pressure sensor for automobiles, for instance, is manufactured, conventionally, a resin molded product of a plurality of electroconductive members which serve as terminals by insert molding is incorporated in a housing for a sensor, and an a pressure sensitive element of the sensor and each of the electroconductive members are connected. In this case, the first element such as a capacitor is connected to each of the electroconductive members in the housing. However, a soldering iron cannot be used in the housing made of resin, and the first element is connected to each of the electroconductive members with an adhesive of an electroconductive epoxy resin or the like. In addition, when the first element is connected to each of the electroconductive members by the electroconductive epoxy resin, silver plating is used for a connecting face so as to improve the electroconductivity. However, silver plating tends to easily migrate, and accordingly the periphery of the first element is required to be filled with a resin for sealing. However, an operation of connecting the first element to each of the electroconductive members in the housing or filling the periphery of the first element with the resin for sealing is complicating, and accordingly there has been a problem that the operation lowers productivity.

Then, there is proposed a process of previously connecting the first element to each of the electroconductive members by soldering, and then forming a resin part which covers each of the electroconductive members and the first element, by insert molding (for instance, see Patent Literature 1 or 2). This process can eliminate an operation of connecting the first element in the housing and an operation of filling the periphery with the resin for sealing, and can enhance the productivity.

### Citation List

### Patent Literature

Patent Literature 1: Japanese Patent Publication 2004-363410
Patent Literature 2: Japanese Patent Publication 11-265965

### Summary of Invention

### Technical Problem

However, when the first element is previously connected to each of the electroconductive members and then the resin part is formed by insert molding as described above, distortion occurs among each of the electroconductive members due to a pressure of a resin which flows into a die at the time of molding, because each of the electroconductive members is connected only by the first element. Thereby, an external force like twisting and bending is applied to the first element from each of the electroconductive members, and there has been a problem that the external force degrades characteristics of the first element.

The present invention has been designed with respect to the above described problems, and an object is to provide a resin molded product which can reduce the external force that is applied to the first element from each of the electroconductive members due to a pressure of the resin at the time of molding, when each of the electroconductive members and the first element are insert-molded with the resin, and a method for producing the same.

### Solution to Problem

In order to achieve the above described object, the present invention provides a resin molded product which is provided with a plurality of electroconductive members that are arranged at spaces from each other in a width direction, a first element that is arranged so as to lie astride each of the electroconductive members, and a resin part that has been formed from a resin by insert molding so as to cover each of the electroconductive members and the first element, including a second element which is connected to each of the electroconductive members so as to lie astride each of the electroconductive members, and fixes the electroconductive members to each other.

In order to achieve the above described object, the present invention also provides a method for producing a resin molded product by arranging a first element so as to lie astride each electroconductive member above a plurality of the electroconductive members which are arranged at spaces from each other in a width direction, and forming a resin part which covers each of the electroconductive members and the first element, by insert molding, including: connecting a second element which fixes the electroconductive members to each other to each of the electroconductive members so as to lie astride each of the electroconductive members; and forming the resin part by arranging each of the electroconductive members, the first element and the second element in a die for insert molding and filling the inside of the die with a molten resin.

Thereby, the second element which fixes the electroconductive members to each other is connected to each of the electroconductive members so as to lie astride each of the electroconductive members. Accordingly, even though a pressure of the resin which flows into the die has been applied to each of the electroconductive members when the resin part that covers each of the electroconductive members and the first element is formed by insert molding, the distortion occurring among each of the electroconductive members is reduced by the second element.

### Advantageous Effects of Invention

The present invention can reduce the distortion occurring among each of the electroconductive members even though the pressure of the resin which flows into the die has been applied to each of the electroconductive members when the resin part that covers each of the electroconductive members and the first element is formed by insert molding, accordingly can greatly reduce the external force like twisting and bending, which is applied to the first element from each of the electroconductive members, and shows such an advantage as not to degrade characteristics of the first element.

### Brief Description of the Drawings

Figure 1 is a perspective view of a resin molded product, which shows a first embodiment of the present invention.
Figure 2 is a perspective view illustrating a connection state of an electroconductive member, a first element and a second element.
Figure 3 is a perspective view of the first element.
Figure 4 is a perspective view of the second element.
Figure 5 is a front view illustrating a step of connecting the first element and the second element.
Figure 6 is a partial cross-sectional front view illustrating a step of connecting the electroconductive member, the first element and the second element.
Figure 7 is a partial cross-sectional front view illustrating a connection state of the electroconductive member, the first element and the second element.
Figure 8 is a side cross-sectional view illustrating a molding step.
Figure 9 is a side cross-sectional view illustrating a molding step.
Figure 10 is a side cross-sectional view illustrating a molding step.
Figure 11 is a partial cross-sectional front view illustrating a step of connecting the electroconductive member, the first element and the second element according to a second embodiment of the present invention.
Figure 12 is a partial cross-sectional front view illustrating a connection state of the electroconductive member, the first element and the second element.
Figure 13 is a perspective view of the first element, which shows a third embodiment of the present invention.
Figure 14 is a front view illustrating a step of connecting the first element and the second element.
Figure 15 is a partial cross-sectional front view illustrating a step of connecting the electroconductive member, the first element and the second element.
Figure 16 is a partial cross-sectional front view illustrating a connection state of the electroconductive member, the first element and the second element.
Figure 17 is a partial cross-sectional front view illustrating a step of connecting the electroconductive member, the first element and the second element according to a fourth embodiment of the present invention.
Figure 18 is a partial cross-sectional front view illustrating a connection state of the electroconductive member, the first element and the second element.
Figure 19 is a perspective view illustrating a connection state of the electroconductive member, the first element and the second element according to a fifth embodiment of the present invention.
Figure 20 is a perspective view illustrating a connection state of the electroconductive member, the first element and the second element according to a sixth embodiment of the present invention.
Figure 21 is a partial cross-sectional front view illustrating a step of connecting the electroconductive member, the first element and the second element according to a seventh embodiment of the present invention.
Figure 22 is a partial cross-sectional front view illustrating a connection state of the electroconductive member, the first element and the second element.
Figure 23 is a perspective view illustrating a connection state of the electroconductive member, the first element and the second element according to an eighth embodiment of the present invention.
Figure 24 is a perspective view of the second element.
Figure 25 is a partial cross-sectional front view illustrating a connection state of the electroconductive member, the first element and the second element.

### Description of Embodiments

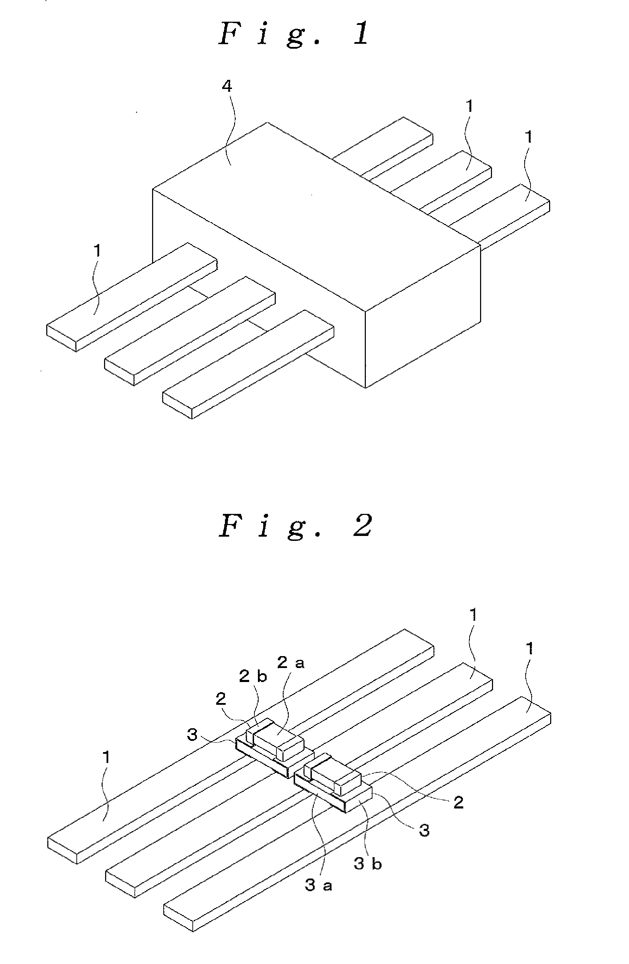

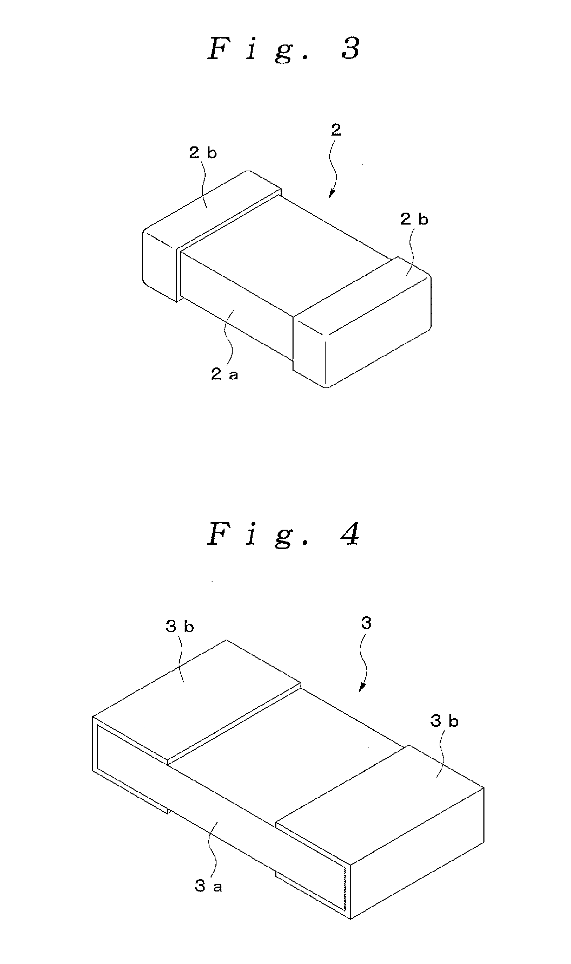

Figure 1 to Figure 10 show a first embodiment of the present invention. A resin molded product illustrated in the figures is used in the production of various devices, for instance, such as a pressure sensor and a rotation magnetic sensor for automobiles.

The resin molded product of the present embodiment includes three electroconductive members 1 which are arranged at spaces from each other in a width direction, two first elements 2 which are arranged so as to lie astride each of the electroconductive members 1, two second elements 3 which are fixed to each of the electroconductive members 1, and a resin part 4 which covers each of the electroconductive members 1, each of the first elements 2 and each of the second elements 3.

Each of the electroconductive members 1 is formed of an electroconductive metal which extends in a tabular shape, and is used as a terminal to be connected to a connecting partner which is not illustrated.

Each of the first elements 2 is formed of an electronic component, for instance, such as a capacitor, a resistor, a varistor and an inductor, and is connected to the second element 3 which is fixed to each of the electroconductive members 1 that are mutually adjacent out of the electroconductive members 1, by soldering. The first element 2 includes a platy component body 2a which is formed of a base material having expected electric characteristics, and a pair of electrodes 2b provided in the both end sides in the width direction of the component body 2a respectively, and each of the electrodes 2b is formed so as to cover both of the end parts in the width direction of the component body 2a.

The second element 3 includes a reinforcing member 3a which is formed from an insulative base material having high strength, for instance, such as high-temperature-fired ceramics and aluminum nitride, and a pair of connecting parts 3b which are provided in the both end sides in the width direction of the reinforcing member 3a respectively, and is connected to each of the electroconductive members 1 which are mutually adjacent out of the electroconductive members 1, by soldering. The reinforcing member 3a is formed in a platy shape which has dimensions in the front and rear direction and width direction that are slightly larger than those of the first element 2, and the dimension in the width direction is larger than the space between adjacent two electroconductive members 1. Each of the connecting parts 3b is formed of an electroconductive metal layer, and is formed so as to cover one face and another face in the thickness direction of the reinforcing member 3a from the both end faces in the width direction thereof.

The resin part 4 is formed from a synthetic resin, for instance, such as PBT, and is formed so as to cover the middle side in the longitudinal direction of each of the electroconductive members 1. Incidentally, the resin part 4 having a rectangular shape has been illustrated in the figure, but the shape is formed into an arbitrary shape according to the shape of a component and the like in the partner side, in which the resin molded product is incorporated. The resin part 4 is formed of the resin in which each of the first elements 2 and each of the second elements 3 which are connected to each of the electroconductive members 1 are insert-molded with the resin, and each of the electroconductive members 1, each of the first elements 2 and each of the second elements 3 are embedded in the inner part of the resin. In this case, the resin having a melting temperature (for instance, 260°C) higher than a melting temperature of a soldered part 5 (for instance, 220°C), which connects each of the electroconductive member 1, each of the first elements 2 and each of the second elements 3, is used for the resin of the resin part 4.

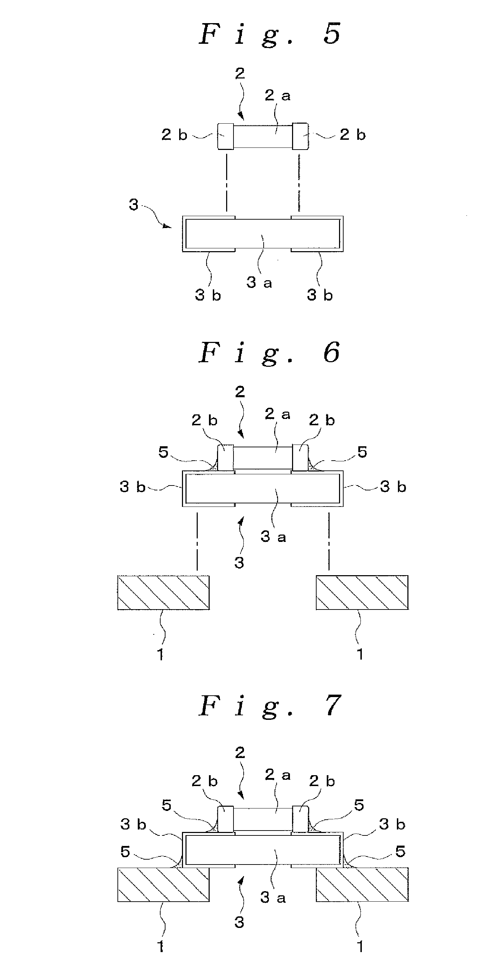

When the above described resin molded product is produced, at first, the first element 2 is mounted on one face in the thickness direction of the second element 3 so as to lap on the second element 3 as is illustrated in Figure 5; and one electrode 2b of the first element 2 is connected to one connecting part 3b of the second element 3 by soldering, and the other electrode 2b of the first element 2 is connected to the other connecting part 3b of the second element 3 by soldering. Next, the second element 3 to which the first element 2 has been connected is mounted so as to lie astride two electroconductive members 1 adjacent to each other so that the other face in the thickness direction faces to the electroconductive member 1 side as is illustrated in Figure 6; and one connecting part 3b of the second element 3 is connected to one electroconductive member 1 by soldering, and the other connecting part 3b of the second element 3 is connected to the other electroconductive member 1 by soldering, as is illustrated in Figure 7. In this case, as is illustrated in Figure 2, one first element 2 and one second element 3 which are connected to each other are connected to the electroconductive member 1 in one end side in the width direction out of the electroconductive members 1 and the electroconductive member 1 in the middle side, and the other first element 2 and the other second element 3 which are connected to each other are connected to the electroconductive member 1 in the other end side in the width direction out of the electroconductive members 1 and the electroconductive member 1 in the middle side. Incidentally, the above described soldering operation may be conducted by using a soldering material and a soldering iron, but may also be conducted by previously forming a solder layer in each of the connecting parts 3b of the second element 3 with a solder paste and the like, and melting the solder with reflow.

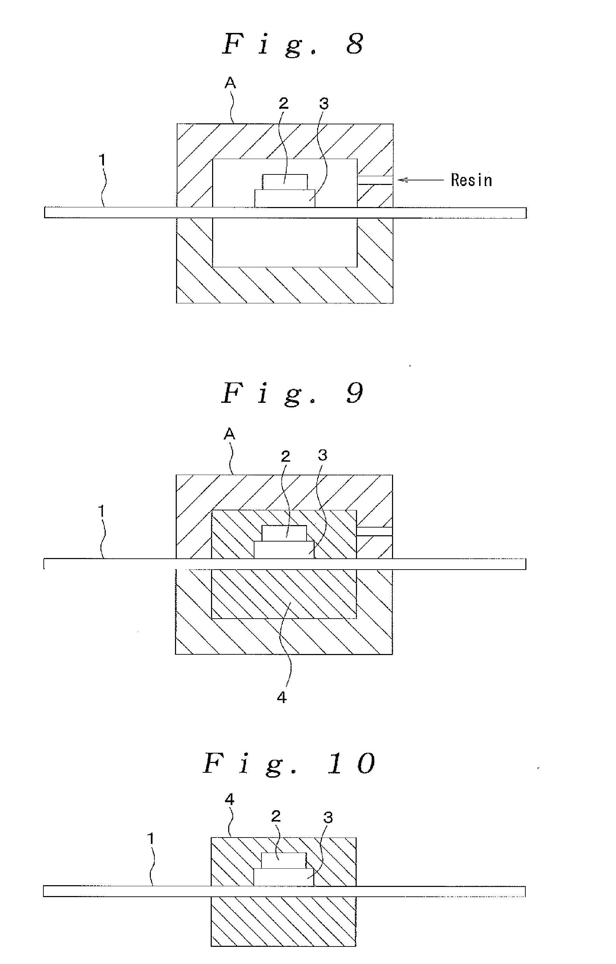

Next, as is illustrated in Figure 8, each of the first elements 2 and each of the second elements 3 in the middle side in the longitudinal direction of the electroconductive member 1 are arranged in a die A, and the inside of the die A is filled with a resin 4' as is illustrated in Figure 9. At this time, a pressure of the resin 4' which flows into the die A is applied to each of the electroconductive members 1, but distortion occurring among each of the electroconductive members 1 is reduced by each of the second elements 3, because each of the electroconductive members 1 is fixed to each other by each of the second elements 3.

In addition, a temperature of the resin 4' which flows into the die A is higher than the melting temperature of the soldered part 5, but it is considered that when the resin 4' has come in contact with the soldered part 5, a solidified layer of the resin 4' is formed on the surface of the soldered part 5. Thereby, a temperature rise in the soldered part 5 by the heat of the resin 4' which flows through the outside of the solidified layer is suppressed by the solidified layer, and the remelting of the soldered part 5 is prevented. In this case, a difference between the temperature of the resin 4' which flows into the die A and the melting temperature of the soldered part 5 is preferably controlled to 90°C or less for preventing the remelting of the soldered part 5.

Then, after the resin 4' has been cured, the die A is removed. Thereby, the resin part 4 is integrally formed with each of the electroconductive members 1, each of the first elements 2 and each of the second elements 3, as is illustrated in Figure 10.

Thus, in the present embodiment, the second element 3 which fixes each of the electroconductive members 1 to each other has been connected to each of the electroconductive members 1 so as to lie astride each of the electroconductive members 1, and accordingly even though the pressure of the resin 4' which flows into the die A has been applied to each of the electroconductive members 1 when the resin part 4 which covers each of the electroconductive members 1 and each of the first elements 2 is formed by insert molding, distortion occurring among each of the electroconductive members 1 can be reduced by the second element 3. Thereby, the method according to the present embodiment can greatly reduce the external force like twisting and bending, which is applied to the first element 2 from each of the electroconductive members 1, and thereby shows such an advantage as not to degrade characteristics of the first element 2.

In addition, the second element 3 has been formed of an insulative reinforcing member 3a which extends over the electroconductive member 1 to which the first element 2 is connected, and the connecting parts 3b which are provided on the both end sides of the reinforcing member 3a respectively, and the connecting parts 3b have been connected to the electroconductive members 1 respectively. Accordingly, the second element 3 can be formed into a shape equal to that of the first element 2, and the second element 3 can be easily connected to the electroconductive member 1 together with the first element 2. In this case, the connecting parts 3b are insulated from each other by the reinforcing member 3a, accordingly the electroconductive members 1 do not conduct electricity to each other due to the second element 3, and there is an advantage that the second element 3 does not give influence on the characteristics of the first element 2.

Furthermore, the first element 2 and the second element 3 have been arranged so as to overlap each other in the thickness direction, and each of the electrodes 2b of the first element 2 has been connected to each of the connecting parts 3b of the second element 3, respectively. Accordingly, the mounting spaces for the first element 2 and the second element 3 on each of the electroconductive members 1 can be reduced, and the resin part 4 can be miniaturized in a longitudinal direction of each of the electroconductive members 1.

In this case, the first element 2 has been arranged in one face side in the thickness direction of the second element 3, and the connecting part 3b on the other face side in the thickness direction of the second element 3 has been connected to the electroconductive member 1. Accordingly, the one face and the other face in the thickness direction of the second element 3 can be connected to the first element 2 and the electroconductive member 1 respectively, and thereby the connecting operation can be easily conducted.

In addition, each of the electroconductive members 1, each of the first elements 2 and each of the second elements 3 have been connected by soldering, and the resin part 4 has been formed by filling the die A with the resin 4' having the melting temperature higher than that of the soldered part 5. Accordingly, the structure enables the solder to be used, which does not use lead and has a low melting point, for instance, and is also effective for preventing the first element 2 from deteriorating due to high temperature at the time of soldering.

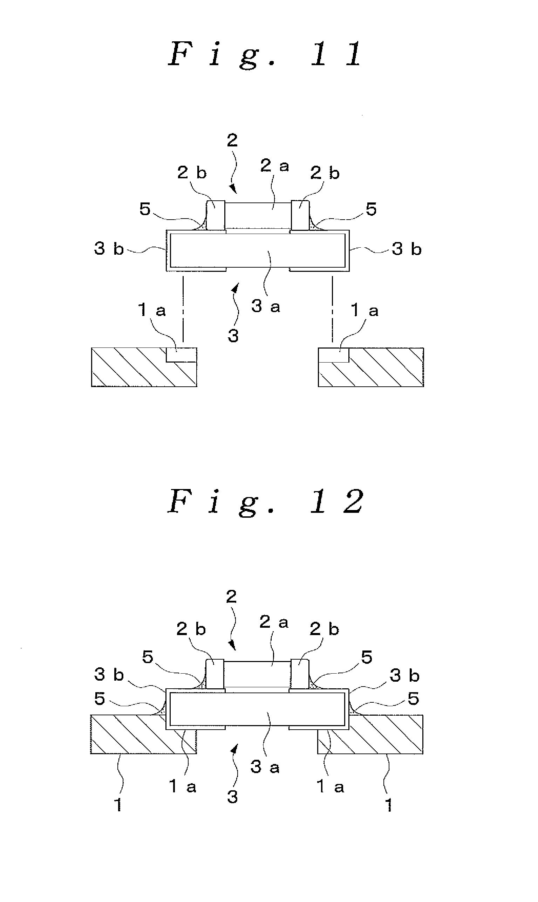

Incidentally, the resin molded product shown in the above described Embodiment 1 has had the second element 3 connected to the surface of the electroconductive member 1 which has been formed in a tabular shape. However, if the second element 3 is engaged with a recess part 1a in a thickness direction, which has been provided in the electroconductive member 1, as is shown in the second embodiment of Figure 11 and Figure 12, and the electroconductive member 1 is connected to the second element 3, the whole height of the electroconductive member 1, the first element 2 and the second element 3 after having been connected can be reduced, and thereby the resin part 4 can be miniaturized in a vertical direction. In this case, because the second element 3 is engaged with the recess part 1a, the second element 3 can be also correctly positioned with respect to the electroconductive member 1.

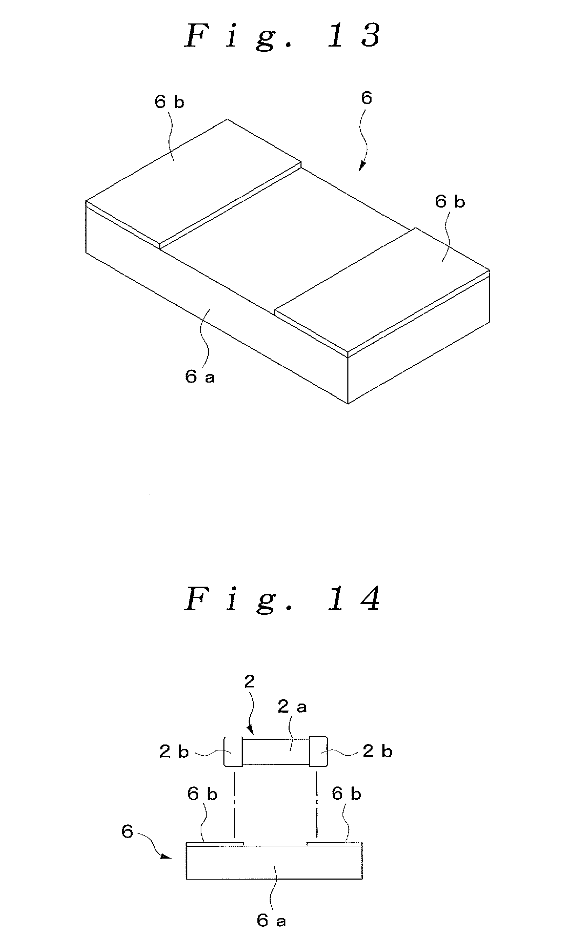

In addition, the resin molded product shown in the above described Embodiment 1 has had the first element 2 arranged on one face side in the thickness direction of the second element 3, and the other face side in the thickness direction of the second element 3 connected to the electroconductive member 1. However, it is also acceptable to arrange the first element 2 on one face side in the thickness direction of the second element 6, and connect one face side in the thickness direction of the second element 6 to the electroconductive member 1, like the second element 6 shown in the third embodiment in Figure 13 to Figure 16.

Specifically, the second element 6 is formed of the insulative reinforcing member 6a which is similar to that of the first embodiment, and the connecting parts 6b provided on both sides in the width direction of the reinforcing member 6a respectively. Each connecting part 6b is provided only on one face in the thickness direction of the reinforcing member 6a.

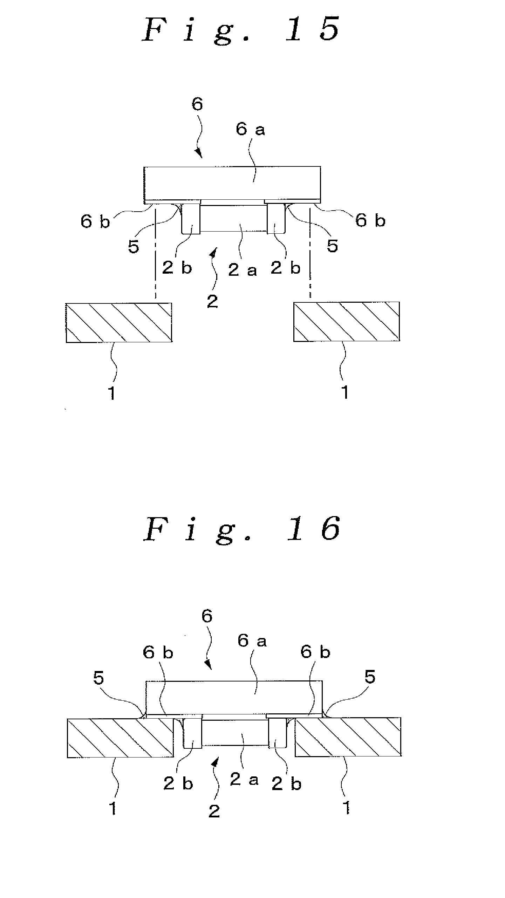

In the present embodiment, as is illustrated in Figure 14, the first element 2 is mounted on one face in the thickness direction of the second element 6 so as to lap on the second element 6; and one electrode 2b of the first element 2 is connected to one connecting part 6b of the second element 6 by soldering, and the other electrode 2b of the first element 2 is connected to the other connecting part 6b of the second element 6 by soldering. Next, the second element 6 to which the first element 2 has been connected is reversed in the thickness direction, is mounted on two electroconductive members 1 adjacent to each other so as to lie astride the two electroconductive members 1 so that one face in the thickness direction faces to the electroconductive member 1 side, as is illustrated in Figure 15; and one connecting part 6b of the second element 6 is connected to one electroconductive member 1 by soldering, and also the other connecting part 6b of the second element 6 is connected to the other electroconductive member 1 by soldering, as is illustrated in Figure 16.

Thereby, the first element 2 and the electroconductive member 1 are each arranged on the same face (one face in thickness direction) of the second element 6, and the first element 2 is arranged between two adjacent electroconductive members 1. Accordingly, the whole height of the electroconductive member 1, the first element 2 and the second element 3 after having been connected can be reduced, and the resin part 4 can be miniaturized in a vertical direction.

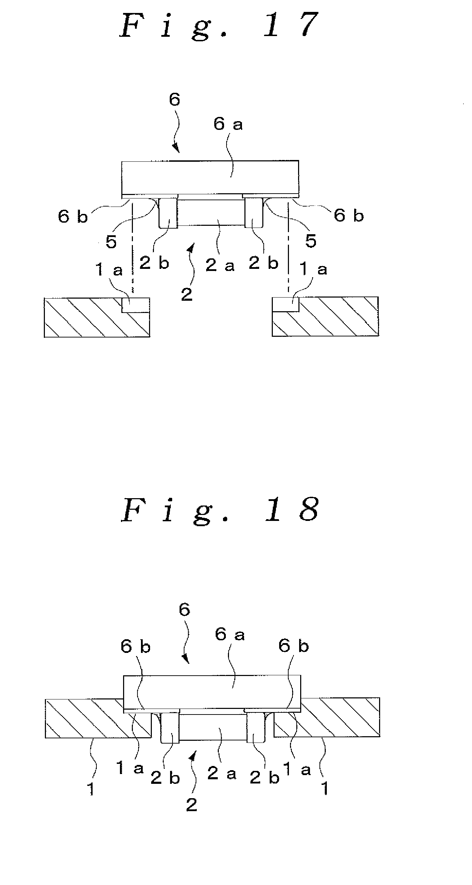

In this case, as is shown in the fourth embodiment of the Figure 17 to Figure 18, if the second element 6 is engaged with the recess part 1a which has been provided in the electroconductive member 1 similarly to that in the second embodiment, and is connected to the electroconductive member 1, the whole height of the electroconductive member 1, the first element 2 and the second element 6 after having been connected can be more reduced, and the configuration is extremely advantageous for miniaturizing the resin part 4 in a vertical direction. In this case, because the second element 6 is engaged with the recess part 1a similarly to that in the second embodiment, the second element 6 can be also correctly positioned with respect to the electroconductive member 1.

Incidentally, the above described third and fourth embodiments show a modification example of the second element, and other configurations and a method for insert-molding the resin part 4 are similar to those in the above described first embodiment.

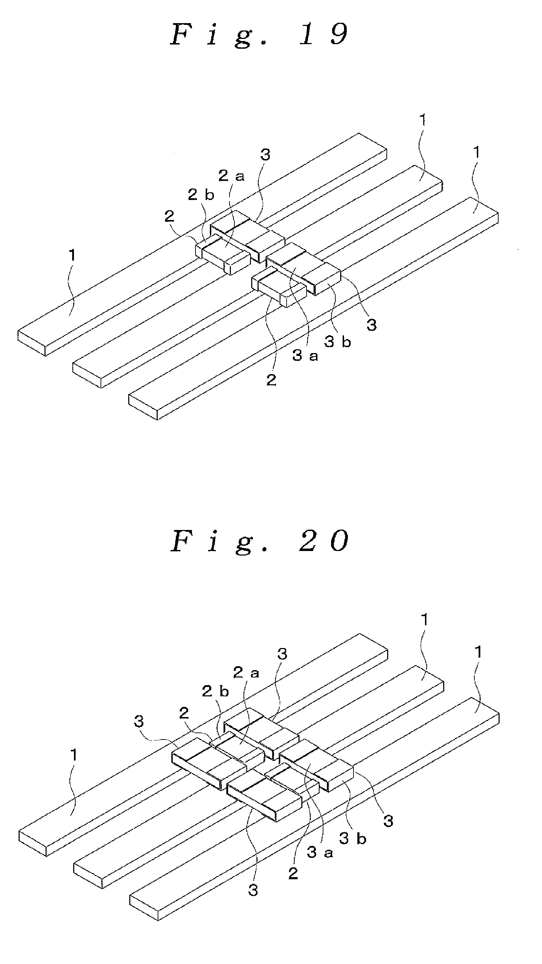

In addition, the resin molded product shown in the above described first embodiment to fourth embodiment has had the first element 2 and the second element 3 connected to each other so as to overlap with each other in the thickness direction. However, it is also acceptable to arrange the first element 2 and the second element 3 so as to be aligned adjacent to each other in the longitudinal direction of the electroconductive member 1, as is shown in the fifth embodiment of Figure 19 and the sixth embodiment of Figure 20. In this case, it is also acceptable to arrange one second element 3 in one side of the front and rear direction of one first element 2 as in the fifth embodiment, or to arrange two second elements 3 in both sides of the front and rear direction of one first element 2 as in the sixth embodiment.

Incidentally, resin molded products shown in the above described fifth and sixth embodiments have employed the second element 3 which is similar to that in the first embodiment, but may employ the second element 6 which is similar to that in the third embodiment. In this case, it is also acceptable to provide a recess part in the electroconductive member 1 with which the first element 2 and the second element 3 (6) are engaged similarly to that in the second or fourth embodiment.

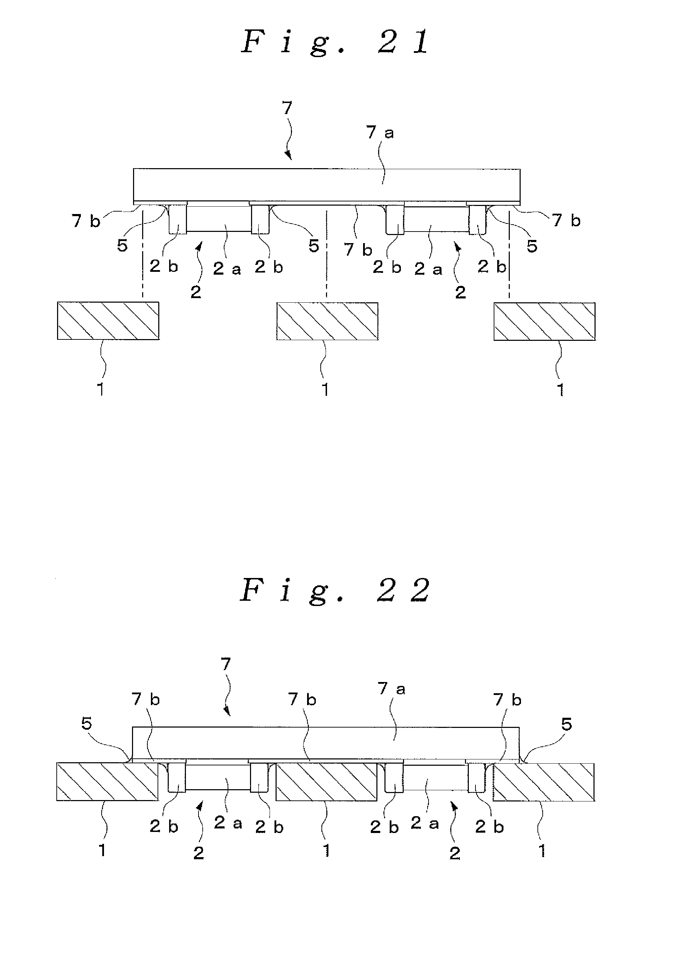

In addition, the second element 3 (6) shown in each of the above described embodiments has been fixed to every two electroconductive members 1 adjacent to each other out of three electroconductive members 1 so as to lie astride the two electroconductive members 1. However, it is also acceptable to connect a second element which has been formed of an insulative reinforcing member 7a that extends over three electroconductive members 1 in the width direction, and a plurality of connecting parts 7b that are provided in one end side, the other end side and the middle side in the width direction of the reinforcing member 7a respectively, to all of three electroconductive members 1, as is the second element 7 which is shown in the seventh embodiment of Figure 21 and Figure 22.

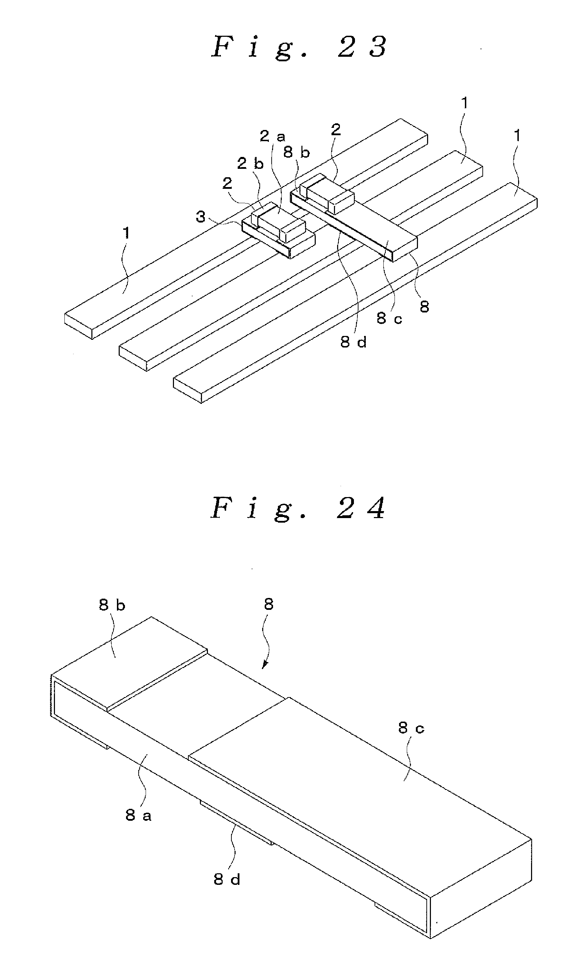

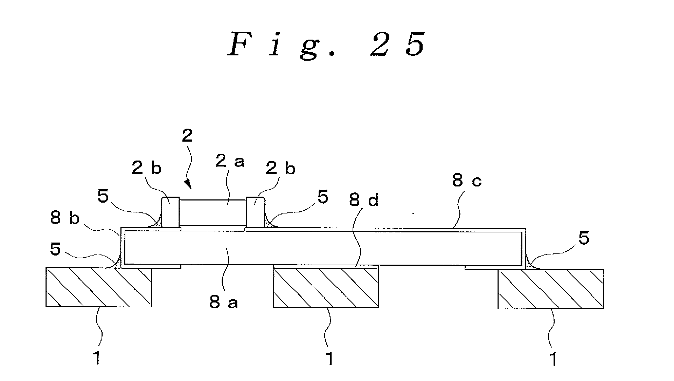

Furthermore, resin molded products shown in each of the above described embodiments have had each one first element 2 connected to the two electroconductive members 1 adjacent to each other out of the electroconductive members 1, respectively. However, it is also be acceptable to connect one first element 2 to two electroconductive members 1 which are arranged in both ends in the width direction, like a second element 8 shown in an eighth embodiment of Figure 23 to Figure 25. In this case, the other first element 2 is connected to two electroconductive members 1 which are arranged in one end side in the width direction and in the middle side, by using the second element 3 similar to that in the first embodiment.

The second element 8 in the present embodiment is formed of: an insulative reinforcing member 8a which extends in a width direction so as to lie astride three electroconductive members 1; a first connecting part 8b which is provided so as to lie astride a top face, a side face and a bottom face in one end side in the width direction of the reinforcing member 8a; a second connecting part 8c which is provided on a top face so as to lie astride the middle side and the other end side in the width direction, and on a side face and a bottom face in the other end side in the width direction of the reinforcing member 8a so as to lie astride the faces; and a third connecting part 8d which is provided on the bottom face in the middle side in the width direction of the reinforcing member 8a.

In the present embodiment, the first element 2 is arranged on the top face (one face in thickness direction) of the second element 8. In this case, one electrode 2b of the first element 2 is connected to the first connecting part 8b of the second element 8, and the other electrode 2b is connected to the second connecting part 8c of the second element 8. The first connecting part 8b of the second element 8 is connected to the electroconductive member 1 in one end side in the width direction, and the second connecting part 8c of the second element 8 is connected to the electroconductive member 1 in the other end side in the width direction. Thereby, the first element 2 is connected to the two electroconductive members 1 which are arranged in the both ends in the width direction. In addition, the third connecting part 8d of the second element 8 is connected to the electroconductive member 1 in the middle side in the width direction. In this case, the third connecting part 8d is not connected to the first element 2, but is fixed to the electroconductive member 1 in the middle side in the width direction. Accordingly, the structure is effective for reducing distortion occurring between each electroconductive member 1, by the second element 8. For information, it is also acceptable to provide the third connecting part 8d as needed.

In addition, a resin molded product shown in each of the above described embodiments has had each of the electroconductive members 1, each of the first elements 2 and each of the second elements 3 connected by soldering. However, it is also acceptable to connect the member and the elements by using an electroconductive adhesive such as a silver paste, for instance.

### Reference Signs List

electroconductive member, 2 ... first element, 3 ... second element, 3a ... reinforcing member, 3b ... connecting part, 4 ... resin part, 5 ... soldered part, 6 ... second element, 6a ... reinforcing member, 6b ... connecting part, 7 ... second element, 7a ... reinforcing member, 7b ... connecting part, 8 ... second element, 8a ... reinforcing member, 8b ... first connecting part, 8c ... second connecting part, 8d ... third connecting part, A ... die.

## Claims

1. A resin molded product which is provided with a plurality of electroconductive members that are arranged at spaces from each other in a width direction, a first element that is arranged so as to lie astride each of the electroconductive members, and a resin part that has been formed from a resin by insert molding so as to cover each of the electroconductive members and the first element, comprising:
a second element which is connected to each of the electroconductive members so as to lie astride each of the electroconductive members, and fixes the electroconductive members to each other.

2. The resin molded product according to claim 1, wherein
the second element is formed of an insulative reinforcing member that extends so as to lie astride each of the electroconductive members and a plurality of connecting parts that are connected to each of the electroconductive members respectively.

3. The resin molded product according to claim 2, wherein
the first element and the second element are arranged so as to overlap with each other in a thickness direction, and the first element is connected to the connecting part of the second element.

4. The resin molded product according to claim 3, wherein
the first element is arranged on one face side in a thickness direction of the second element, and the other face side in the thickness direction of the second element is connected to the electroconductive member.

5. The resin molded product according to claim 3, wherein the first element is arranged on one face side in a thickness direction of the second element, and the one face side in the thickness direction of the second element is connected to the electroconductive member so that the first element lies between each of the electroconductive members.

6. The resin molded product according to claim 1, 2, 3, 4 or 5, wherein
a recess part for engaging the second element therewith in a thickness direction is provided in each of the electroconductive members.

7. A method for producing a resin molded product by arranging a first element so as to lie astride each electroconductive member above a plurality of the electroconductive members which are arranged at spaces from each other in a width direction, and forming a resin part which covers each of the electroconductive members and the first element, by insert molding, comprising:
connecting a second element which fixes the electroconductive members to each other, to each of the electroconductive members so as to lie astride each of the electroconductive members; and
forming the resin part by arranging each of the electroconductive members, the first element and the second element in a die for insert molding, and
also filling the inside of the die with a molten resin.

8. The method for producing the resin molded product according to claim 7, wherein
each of the electroconductive members, the first element and the second element are connected by soldering; and
the resin which fills the inside of the die thereby to form the resin part has a melting temperature higher than that of a soldered part.

9. The method for producing the resin molded product according to claim 8, wherein
a temperature difference between the melting temperature of the resin which is filled in the inside of the die and a melting temperature of the soldered part is 90°C or less.
